Europäisches Patentamt

European Patent Office

Office européen des brevets

(11) Publication number: **0 307 980 B1**

## EUROPEAN PATENT SPECIFICATION

(45) Date of publication of patent specification: **16.09.92**

(51) Int. Cl.5: **G06K 15/12**, H01S 3/096, H01S 3/103, H01S 3/133

(21) Application number: **88201657.9**

(22) Date of filing: **02.08.88**

Divisional application 91119581.6 filed on 02/08/88.

(54) **A control circuit for a laser printer.**

(30) Priority: **25.08.87 NL 8701986**

(43) Date of publication of application:
**22.03.89 Bulletin 89/12**

(45) Publication of the grant of the patent:
**16.09.92 Bulletin 92/38**

(84) Designated Contracting States:
**DE FR GB IT NL**

(56) References cited:
**DE-A- 3 025 089**
**DE-A- 3 025 267**
**US-A- 4 612 555**

**PATENT ABSTRACTS OF JAPAN, vol. 7, no. 194 (E-195)(2339), 24 August 1983**

**NTG-FACHBERICHTE, vol. 59, Proceedings 3rd European Conf. on Optical Communication, Munich, 14-16 September, 1977, pages 208-210; VDE-Verlag, Berlin, DE, S.R. SALTER et al.: "Laser automatic level control circuits for optical communications systems"**

**TRANSACTIONS OF THE IECE OF JAPAN, vol. E 65, no. 10, October 1982, pages 584-585; Tokyo, JP, H. UKITA et al.: "Direct FM color video signal recording with diode lasers"**

(73) Proprietor: **Océ-Nederland B.V.**
**St. Urbanusweg 43**
**NL-5914 CC Venlo(NL)**

(72) Inventor: **Joosten, Louis Gerardus Josephus**
**Willem van Hornestraat 29**
**NL-5988 AP Helden(NL)**
Inventor: **Stemkens, Matheas, Theodorus Maria**
**Van Montfortstraat 34**
**NL-5991 CL Baarlo(NL)**

(74) Representative: **Hanneman, Henri W.A.M. et al**
**Océ-Nederland B.V. Patents and Information**
**Postbus 101**
**NL-5900 MA Venlo(NL)**

## Description

This invention relates to a control circuit for a laser printer

A control circuit of this kind is known from US Patent 4 612 555. The laser printer described therein comprises a switching amplifier for controlling a laser diode, a variable current source being used as a common emitter resistor for two switching transistors. A second current source is described for adjusting the base current through the laser diode. A photodiode is also provided which measures the emitted amount of light and the energization current through the laser diode is determined on the basis of this measurement.

It is a property of a laser diode that when current is supplied it takes some time before the laser diode emits light. This is a particularly troublesome property if the laser diode is used in a high speed and/or high resolution laser printer. On the basis of a switch-on delay time of about 6 nsec and a writing frequency of about 10 MHz, the switch-on point of the laser lies approximately 6 $\mu$m later than expected. A broadening of this kind, for example, with respect to fonts with a resolution of 20 image dots per mm, is visually disturbing.
From JP-A-58 95885 a control circuit for a laser printer is known wherein the input signal is expanded by means of a delay line having a fixed delay time.
From NTG-FACHBERICHTE, vol.59, Third European Conference on Optical Communication, Conference Proceedings, September 14-16, 1977, pages 208-210 a control circuit for optical communications systems is known, wherein the time is determined elapsing between the reception of the data and the rise of the signal delivered by a photodiode by integrating the photodiode voltage. This integrated signal is used to control the bias-circuit of the laser-control system and maintains the length of all the light-pulses equal. For imaging purposes, wherein the length of the data pulses and the light pulses must be equal, this document does not give a solution.

The object of the invention is to provide a control circuit in which this and other disadvantages are obviated. According to the invention this object is attained in a control circuit according to the preamble by the measures from the characterising part of claim 1. Consequently, the line written by the laser printer corresponds exactly to the image information supplied and the base current adjust ment can be effected less critically.

These and other advantages will be explained in the following description with reference to the accompanying drawings wherein:
Fig. 1 is a diagram of a control circuit for a laser printer,

Fig. 2 is a diagram of a laser switching amplifier,
Fig. 3 is a diagram of a correction circuit,
Fig. 4 illustrates the signal forms which occur in this correction circuit,
Fig. 5 is a diagram of a protective circuit,
Fig. 6 is a diagram of a voltage-to-current converter,
Fig. 7 is a diagram of a light intensity-to-voltage converter,
Fig. 8 is a diagram of a sample-and-hold circuit,
Fig. 9 is a diagram of a differential amplifier, and
Fig. 10 is a diagram of a regulating circuit.

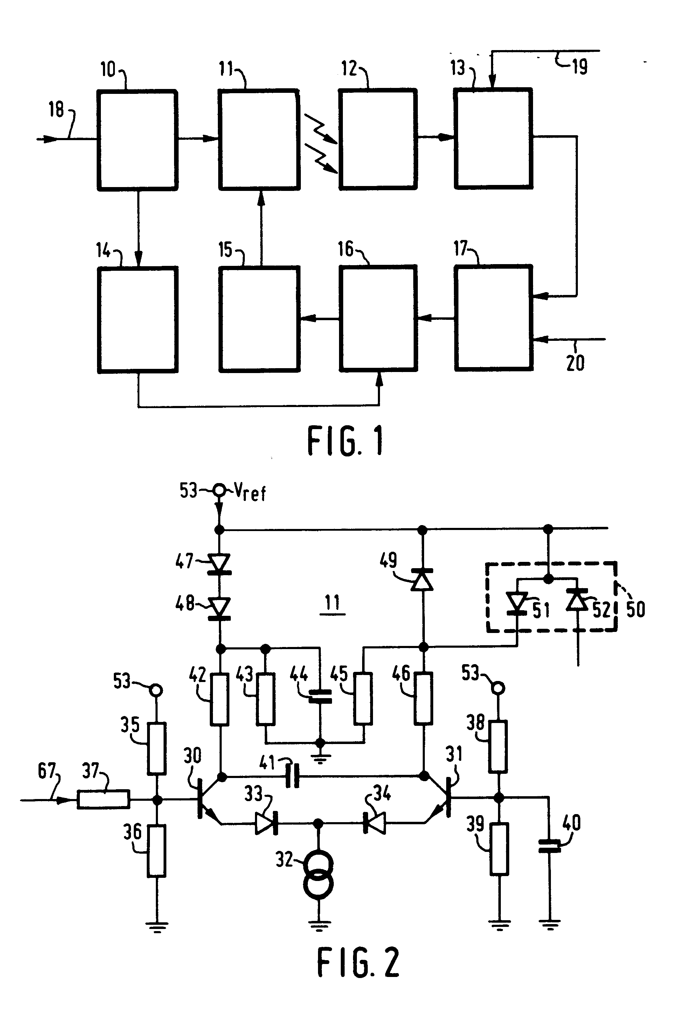

Fig. 1 is a diagram of a control circuit for a laser printer. A control circuit of this kind modulates a laser diode by means of image or video signals. The modulated laser beam is deflected linewise over a photosensitive medium by means of a polygonal mirror. The laser diode is driven by a laser switching amplifier 11. The laser diode is disposed in an envelope which also contains a photodiode which delivers a signal related to the amount of light emitted by the laser diode. The related signal is converted into a voltage by a light intensity-to-voltage converter 12. This voltage is fed to a sample-and-hold circuit 13. After an image line has been written, a sample signal is fed via a line 19 to the sample-and-hold circuit 13. The voltage which was present at the time of sampling is retained until the next sampling signal. During this time the laser is on. This voltage is fed to a differential amplifier 17 and is compared with a reference signal fed via line 20. This reference signal represents the required light output of the laser diode. In the event of inequality of the two signals a differential signal is generated and is fed to a regulating circuit 16. Regulating circuit 16 delivers a d.c. voltage which is fed to a voltage-to-current converter 15. The current generated here acts as switching current for the laser diode. If the laser diode output is too low, the current will increase via circuits 12, 13, 17, 16 and 15 so that the light output increases, and so on.

The regulating system described corrects the light output on each image line while the response time of the regulating circuit is equivalent to a number of image lines.

The image signal is fed via line 18 to a correction circuit 10. As will be described hereinafter, this circuit 10 compensates for the delayed light emission of the laser diode. The corrected image signal is fed as a modulation signal to the laser switching amplifier 11.

The image signal is also fed (via correction circuit 10) to a protective circuit 14, and the output of the latter is connected to the regulating circuit 16.

Fig. 2 illustrates the laser switching amplifier diagrammatically. The heart of the circuit is formed by a differential amplifier having a common current source 32 in the emitter leads of transistors 30 and 31. The right-hand chain of the differential amplifier is formed by transistor 31, resistors 45 and 46, and laser diode 51. The left-hand chain of the differential amplifier is formed by transistor 30, resistors 42 and 43, capacitor 44, and diodes 47 and 48. The base of transistor 31 is at a fixed potential via a voltage divider formed by resistors 38 and 39. For this purpose the voltage divider is connected to a reference voltage source 53 while the base is connected to a capacitor 40 in order to ensure a stable potential on this base. The collector lead of transistor 31 contains a collector resistor 46 and in series with the latter a protective diode 49 which is connected in the cut-off direction to the reference voltage 53. The base of the input transistor 30 is also at a fixed potential via a voltage divider formed by the resistors 35 and 36. The modulation signal is fed to the base of transistor 30 via resistor 37.

If the modulation signal on line 67 is higher than the voltage on the base of transistor 31, transistor 30 will conduct and transistor 31 will be cut off. The current through transistor 30 is determined by the current source 32.

The base current flowing through the laser diode 51 via resistor 45 will have a value which is determined by the reference voltage 53 and resistor 45.

If the modulation voltage on the base of transistor 30 falls below the base voltage of transistor 31, transistor 30 will be cut off and transistor 31 will conduct. The energizing current which will now flow through the laser diode 51 is also determined by the current source 32 since the value of resistor 45 is much larger than the value of the collector resistor 46. Diodes 33 and 34 decouple the base-emitter capacitances of the transistors 30 and 31. This obviates current oscillations.

At times when the laser diode 51 is "on", the photodiode 52 disposed in a housing 50 with the laser diode 51 will deliver a photo-current to the light intensity-to-voltage converter 12.

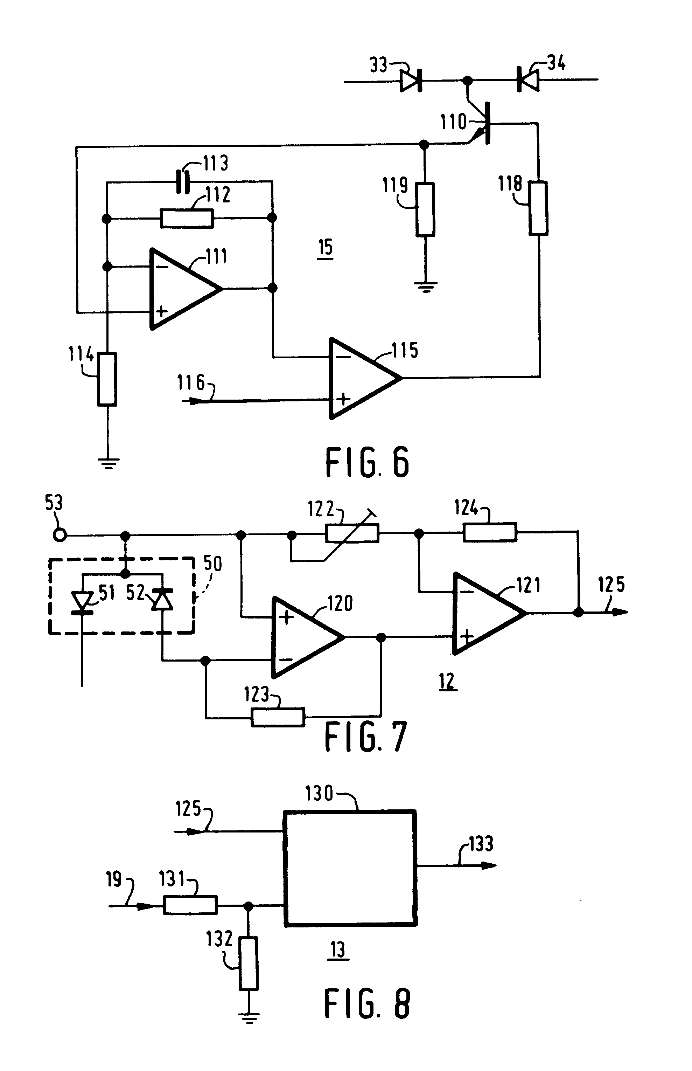

In this converter 12 (Fig. 7) the diode current is fed to the inverting input of an amplifier 120 which together with resistor 123 converts this current into a voltage. On line 125 amplifier 121, the gain of which can be set by means of a potentiometer 122 and a resistor 124, gives an output signal whose value at maximum light output of laser diode 51 is equivalent to a predetermined voltage.

This output voltage on the line 125 is fed to the sample-and-hold circuit 130 (Fig. 8). After each written line, a sampling pulse is fed to the sample-and-hold circuit 130 via a line 19 and a voltage divider formed by the resistors 131 and 132. The instantaneous value of the voltage on line 125 thus becomes available on line 133.

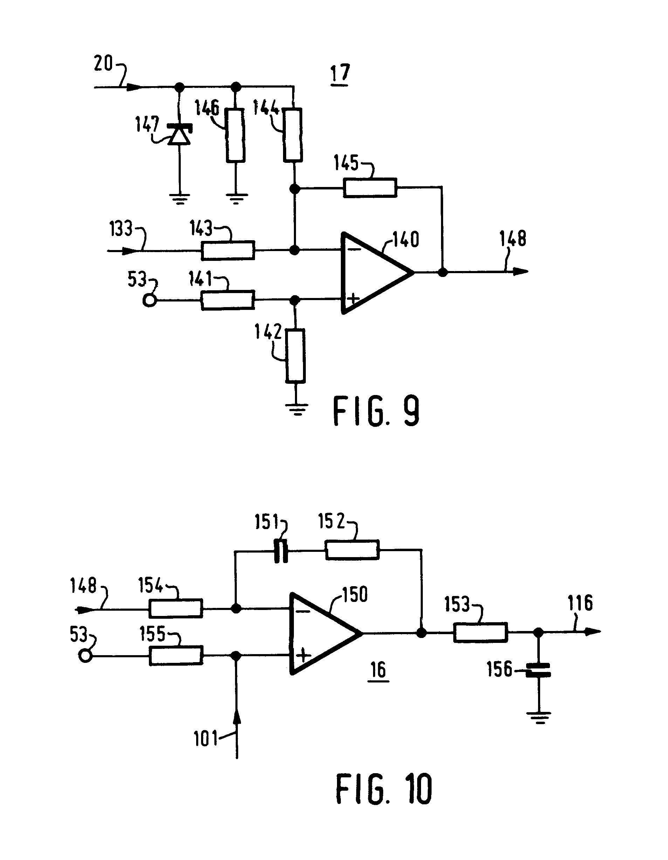

This voltage is fed (Fig. 9) to the inverting input of an amplifier 140 via a resistor 143. In addition, a reference voltage is fed to the inverting input of the amplifier 140 via line 20 and a voltage divider formed by resistors 146 and 144, the value of the reference voltage being related to the required current through the laser diode. The difference between the two voltages is amplified via amplifier 140 and resistor 145 and becomes available on line 148. Zener diode 147 prevents the output voltage on line 148 from being excessive, in the event of an excessive reference voltage on line 20, which whould result in the current through the laser diode exceeding a maximum value. The differential amplifier is set by a voltage divider formed by the resistors 141 and 142.

The differential voltage on line 148 (Fig. 10) is fed to the regulating amplifier 16. This regulating amplifier is constructed as an integrator around the operational amplifier 150, resistor 152 and capacitor 151. The speed of regulation of the integrator is determined by resistors 152 and 154, and capacitor 151. The integrated signal is flattened by a filter formed by resistor 153 and capacitor 156. The positive input of the operational amplifier 150 is connected to a reference voltage 53 via a resistor 155 and also to a protective circuit 14 via line 101.

The output signal of this regulating circuit is fed via line 116 to the voltage-to-current converter 15 (Fig. 6). This converter regulates the current through the laser diode in such manner as to give a constant light output. The variable current source is formed by transistor 110, resistor 119 and the two operational amplifiers 111 and 115. Capacitor 113 serves to stabilize the circuit. The range of regulation of the current source is such that even at the end of the life of the laser diode there is still sufficient current available to supply the maximum light output.

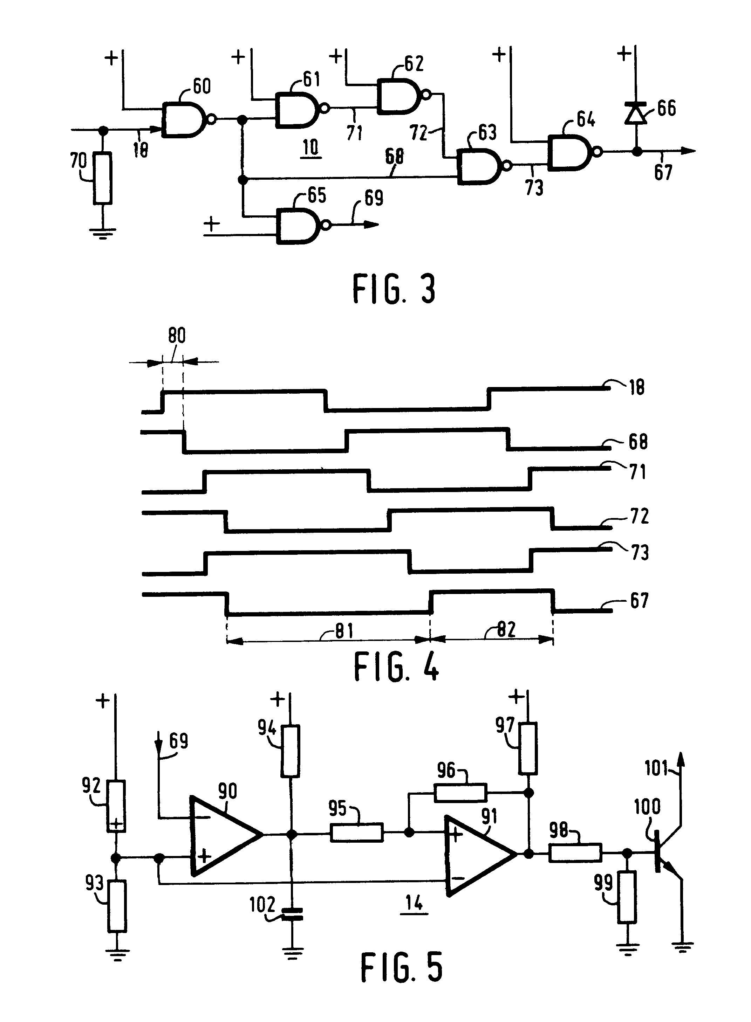

The image signal is fed via correction circuit 10 over line 69 to the protective circuit 14 (Fig. 5) and to the inverting input of the operational amplifier 90 constructed as a comparator circuit. The signal is compared with a d.c. voltage on the non-inverting input of the operational amplifier 90. This d.c. voltage is adjusted by means of resistors 92 and 93. If no image signal is supplied (laser continuously "off"), capacitor 102 will be slowly charged up via resistor 94. If this voltage, which is fed via resistor 95 to the non-inverting input of the second operational amplifier 91, is higher than the voltage on the inverting input, the output of this second operational amplifier goes high and transistor 100 will conduct.

Since the collector of transistor 100 is connected via line 101 to the non-inverting input of the operational amplifier 150 (Fig. 10), the voltage at this point will decrease and the current source will be switched off. This switching-off time occupies approximately two image line times.

If a current is fed to the laser diode, it still takes about 6 nsec before the diode delivers light. When the current is switched off, the light output decreases to zero without delay. In order to correct for this anomaly, correction circuit 10 (Fig. 3) is added to the control circuit. A symmetrical image signal (see also Fig. 4) is fed to an NAND gate 60 via line 18. The output of this signal on line 68 is inverted and delayed for a time 80 with respect to the original image signal. This time 80 is approximately 3 nsec. This signal is fed via 2 NAND gates 61 and 62 and via line 72 to an input of NAND gate 63. The signals on lines 71 and 72 are thus always delayed for a time 80 with respect to the original signal. The signal on line 68 is fed to the other input of NAND gate 63. The leading flank of the resulting signal on line 73 is twice delayed for a time 80 and the trailing flank is delayed for a time 80 four times with respect to the original image signal. Since a "low" signal is required for the laser diode to emit light, the signal on line 73 is inverted again by means of NAND gate 64 and the resulting corrected image signal or modulation signal becomes available on line 67.

The time corresponding to 81 (Fig. 4) is lengthened by 2 x 3 nsec = 6 nsec, with respect to the original image signal, and as from the switching-off time the current through the laser diode is switched on 6 nsec earlier, so that the light delivery starts at exactly the right time (6 nsec later). The "off" time 82 is correspondingly shortened by 6 nsec.

For the correction described it is important that the leading and trailing flanks of the image signal supplied should be symmetrical with respect to one another. This can be achieved by gating the image signal with the laser printer clock signal. In this way image pulse distortion caused by supply lines with stray capacities is completely eliminated.

The correction can also be achieved by allowing the trailing flank of the (inverted) image signal always to go high again 6 nsec later by means of a time circuit.

The correction can also be performed dynamically. According to the invention, the number of pulses delivered by an HF clock signal generator can be counted by an up and down counter in the time elapsing between the image signal going "high" and the laser diode 51 going "on" (determined via the photodiode 52 or another externally disposed diode). When the image signal goes "low" the counter is switched over to a down-counter and the energizing signal remains "high" until the counter has again reached the zero position. The counter is synchronized with the HF clock pulses.

These and all the variations which can be derived therefrom by the skilled addressee in respect of the control circuit for a laser printer will, however, come under the following claims.

## Claims

1. A control circuit for a laser printer comprising a laser switching amplifier (11) for supplying current to a laser diode (51), a photodiode (52) disposed near the laser diode (51) and delivering a signal related to the light output of the laser diode (51), the laser diode being modulated by means of image signals, the control circuit comprising a correction circuit (10) with which the image signal is lengthened by a correction time corresponding or substantially corresponding to the time elapsing between current being supplied to the laser diode (51) and the rise of the signal delivered by the photodiode (52), characterised in that the correction circuit (10) comprises an HF clock signal generator and an up and down counter, the counter counting the HF clock signals during the specific time and, after expiry of the image signal, the counter being switched over to a down-counter and counting down to zero, in synchronism with the HF clock pulses, and the image signal being lengthened during the count down to zero.

## Patentansprüche

1. Steuerschaltung für einen Laserdrucker mit einem Laser-Schalterverstärker (11) für die Stromzufuhr zu einer Laserdiode (51), einer Photodiode (52), die in der Nähe der Laserdiode (51) angeordnet ist und ein Signal bezüglich der Lichtabgabe der Laserdiode (51) liefert, wobei die Laserdiode mit Hilfe von Bildsignalen moduliert wird und die Steuerschaltung eine Korrekturschaltung (10) aufweist, mit der das Bildsignal um eine Korrekturzeit verlängert wird, die zumindest annähernd der Zeit entspricht, die zwischen der Stromzufuhr zu der Laserdiode (51) und dem Anstieg des von der Photodiode (52) gelieferten Signals vergeht, dadurch gekennzeichnet, dass die Korrekturschaltung (10) einen HF-Taktsignalgenerator und einen Aufwärts-Abwärts-Zähler aufweist, der die HF-Taktsignale während der spezifischen Zeit zählt und nach dem Abfall des Bildsignals auf Abwärtszählen umgeschaltet wird und synchron mit den HF-Impulsen auf Null abzählt, und dass das Bildsignal während des Abzählens auf Null verlängert wird.

## Revendications

**1.** Circuit de commande pour une imprimante à laser comprenant un amplificateur de commutation de laser (11) pour fournir du courant à une diode à laser (51), une photodiode (52) disposée près de la diode à laser (51) et délivrant un signal relatif à l'émission de lumière de la diode à laser (51), la diode à laser étant modulée au moyen de signaux d'image, le circuit de commande comprenant un circuit de correction (10) avec lequel le signal d'image est allongé d'un temps de correction correspondant ou pratiquement correspondant au temps s'écoulant entre le courant fourni à la diode à laser (51) et la montée du signal délivré par la photodiode (52), caractérisé en ce que le circuit de correction (10) comprend un générateur de signal d'horloge HF et un compteur-décompteur, le compteur comptant les signaux d'horloge HF pendant le temps spécifique et, après expiration du signal d'image, le compteur étant commuté en décompteur et décomptant jusqu'à zéro, en synchronisme avec les impulsions d'horloge HF, et le signal d'image étant allongé pendant le décomptage jusqu'à zéro.

FIG. 1

FIG. 2

## FIG. 3

## FIG. 4

## FIG. 5

FIG. 6

FIG. 7

FIG. 8

FIG. 9

FIG. 10